# EUROPEAN PATENT SPECIFICATION

(11) **EP 3 879 588 B1**
(45) Date of publication and mention of the grant of the patent: **07.06.2023**
(21) Application number: 21171839.0
(22) Date of filing: 12.09.2011
(51) Int. Cl.: H01L 33/64, H01L 23/36, H01L 23/373, H05K 7/20

(54) **ELECTRIC ACTUATOR**
ELEKTRISCHER AKTUATOR
ACTUATEUR ÉLECTRIQUE

(30) Priority: 28.09.2010 FI 20106001
(43) Date of publication of application: 15.09.2021
(62) Divisional of application: 11828190.6
(73) Proprietor: Becoxs Oy, 00130 Helsinki (FI)
(72) Inventor: Kanervisto, Jari, 33710 Tampere (FI)
(74) Representative: Berggren Oy

(56) References cited:
- EP-A1- 2 020 683
- WO-A1-2008/043540
- DE-A1-102008 045 925
- JP-A- 2003 324 215
- US-A1- 2006 018 608
- US-A1- 2007 262 328
- US-A1- 2010 155 748

## Description

An electric actuator, which actuator consists of an electric actuator arrangement that is sensible to heat and/or that generates heat, the actuator being put together to form a uniform organ, such as a light source, by coupling the electric actuator arrangement with an at least thermally conductive frame part.

Particularly e.g. in LED-lighting/light production putting together of the type of light sources described above is nowadays a problem, since the production is still based on e.g. manual manufacturing, wherein a separate LED component is being glued or fastened by a screw joint e.g. to an aluminium based frame part. When using a screw joint, between the LED component and the aluminium frame is usually installed furthermore a thermally conductive paste or tape. This kind of an intermediate layer is required due to the fact that the surface of aluminium is not totally level, which is why, despite the screw joint, there will be left air between the parts, which weakens thermal transmission. The thermally conductive paste or tape levels the surface roughness of the aluminium and forms a uniform heat transmitting substance layer between the parts in question. In this kind of an implementation, the aluminium frame acts thus as an element that cools the LED, in which connection it is characteristic that the better the cooling is at the back side of the LED, the brighter the LED illuminates thus also enabling as long as possible operating time thereof. An advantage of aluminium, being used as a part of the frame material, is its property of having a good thermal conductivity, whereby aluminium has a disadvantage first of all due to its thermal expansion and on the other hand due to its electric conductivity and even "extensive" thermal conductivity (high surface temperature) in certain implementations. Furthermore, aluminium needs usually to be separately painted or coated in order to prevent it from becoming oxidized. DE102008045925 discloses an optoelectronic component having at least two connecters for electrical contacting of the component, a housing body, in which the connecters are embedded, a heat sink, which is connected to at least one connector (2), for dissipating heat. WO2008043540 discloses a lighting armature or light generator, comprising a housing, a light source, drive electronics for driving the light source and separate cooling fins for conducting heat. US20100155748 discloses emitter package lead frames, emitter packages and LED screens that provide for improved color emission uniformity at different viewing angles. A casing of a package carries an integral lead frame. The lead frame comprising a plurality of electrically conductive connection parts used to conduct an electrical signals to the package's light emitters, and to also assist in dissipating heat generated by the emitters.

It is the aim of the electric actuator according to the present invention to achieve a decisive improvement in the problems described above and thus to raise essentially the level of prior art. In order to carry out this aim, the invention is mainly characterized by what is stated in the independent claim.

As the most important advantages of the method of manufacturing electric actuators may be mentioned simplicity and efficiency of the method itself and the actuators to be manufactured by the same, in which case a totally new kind of an actuator is made possible by exploiting a very usual processing as such, whereby the actuator has its electric actuator arrangement and thermally conductive and electrically non-conductive frame part built together from manufacturing onwards. Thus a manual manufacturing of a LED light source e.g. as described in the beginning, can be avoided along with use of an extraordinary thermally conductive tape or paste that is usually needed in this context.

When applying the method, a manufacturing material forming the frame part is being processed in connection with the actuator arrangement by exploiting mold technique, whereby the actuator arrangement is being sunk by its heat sensitive or thermally conductive surface at least partly inside the frame part. Thus, as a particularly advantageous embodiment particularly in putting together of a LED light source, at a bottom of the LED is being processed advantageously furthermore an at least thermally conductive composite material that is based on rubber and/or plastic, whereby thanks to its thermal transmission properties also heat strain directed to the LED component during the processing can be kept adequately low. When exploiting the method advantageously further, the actuator arrangement is being coupled with electronics operating the same at least partly internally in the frame part by exploiting in the processing an essentially electrically non-conductive manufacturing material, which for its part minimizes significantly manufacturing costs.

The method enables thus both technically and economically taken remarkable advantages when compared e.g. to the present manual manufacturing of LED light sources. The invention enables very accurate measured actuators that have furthermore a freedom in shape, whereby an advantage of the actuators is in addition to lightness, a finished appearance thereof from the manufacturing onwards as well as good dampproofness characteristics.

Other advantageous embodiments of the have been presented in the dependent claims related thereto.

In the following description, the invention is being illustrated in detail with reference to the appended drawings, in which
in figures 1a - 1d
   are shown as exemplary cross sectional views two alternative compositions of a traditionally manufactured LED light source (figures 1a & 1b), and as a front view and as a side view two traditional LED-components (figures 1c & 1d),
in figures 2a and 2b
   is shown an advantageous actuator according to the invention being enabled by the method such as a LED light source being manufactured by the method and being put together in two alternative ways,
in figures 3a - 3h
   are shown some advantageous actuator compositions being based on the LED component shown in figure 1c and manufactured by the method according to the invention as alternative embodiments in respect with the ones shown in figures 2a and 2b,
in figures 4a - 4b
   is shown an actuator based on the LED component according to figure 1d as two alternative compositions, and furthermore
in figures 5a - 5c
   are shown corresponding cross sectional views of three alternative compositions enabled by the method, the compositions containing several electric actuator arrangements.

A method for manufacturing of an electric actuator, which actuator consists of an electric actuator arrangement 1 that is sensible to heat and/or that generates heat, the actuator being put together to form a uniform organ, such as a light source, by coupling the electric actuator arrangement with an at least thermally conductive frame part 2. The actuator arrangement 1 and the frame part 2; 2' are being coupled with each other in an integral manner by processing a manufacturing material forming the frame part 2; 2' in connection with the actuator arrangement 1.

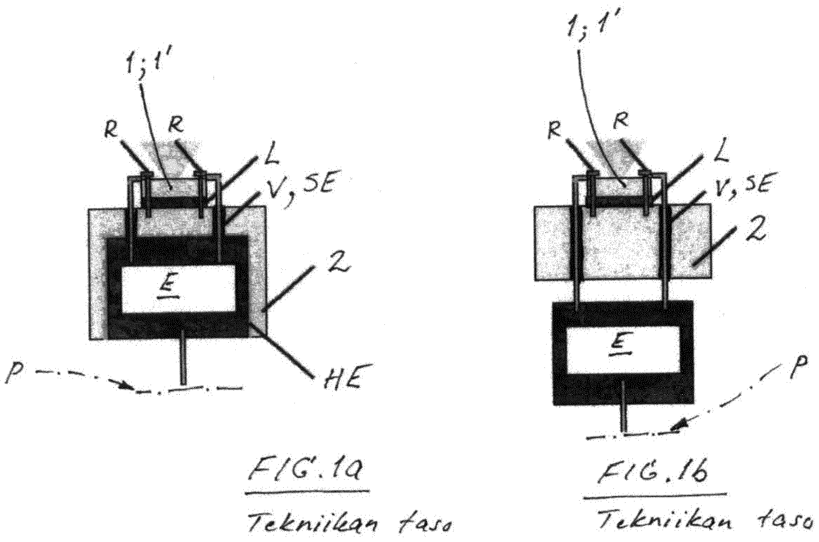

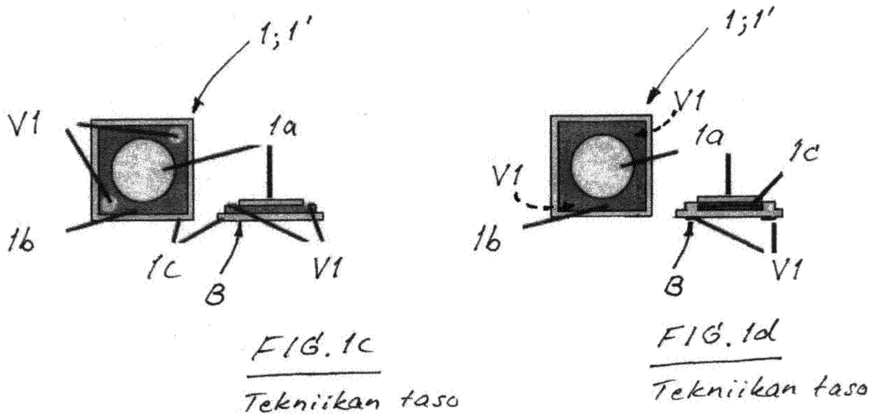

In figures 1a and 1b is shown a usual LED light source, being put together by a traditional method manually, in which a LED component 1; 1', as shown particularly in figure 1c, that consists of an aluminium frame 1c, being equipped with contact surfaces V1 on its upper surface 1b that has an electrically insulating surface treatment, and a diode 1a, the LED component being coupled in the composition according to figure 1a by a screw joint R with an aluminium frame 2, inside of which is arranged in an integral and screened HE manner electronics E operating the LED component, whereby the electronics gets its current from a power source P. In the implementation according to figure 1a, the contact surfaces V1 of the LED-component 1; 1' are connected inside the aluminium frame 2 by electrically insulated SE conductors V with the electronics unit E. In the composition according to figure 1b, there has been exploited for its part a separate electronics unit E in respect with the aluminium frame 2. In figure 1d is shown an alternative LED light source with respect to the one shown in figure 1c, in which the contact surfaces V1 are at the bottom surface of the LED component 1; 1'.

As an advantageous embodiment of the method, the manufacturing material forming the frame part 2; 2' is being processed in connection with the actuator arrangement 1 by exploiting mold technique.

Furthermore, the actuator arrangement 1 is being processed in connection with the manufacturing of the actuator particularly by its heat sensitive and/or heat generating surface B to be at least partly sunk inside the frame part 2', which manifests itself from all of the appended exemplary drawings presenting actuators that are manufactured by the method.

Furthermore as an advantageous embodiment of the method, as the manufacturing material of the frame part 2; 2' or as a part thereof is being used thermosetting plastic, thermoplastic, vulcanized rubber and/or thermoplastic elastomer, which is being processed in connection with the actuator arrangement 1 by injection molding, die-casting or in a corresponding manner.

When the electric actuator assembly 1 comprises one or several heat generating electric actuators, such as LED components 1' or like as presented in the appended drawings, at the bottom B thereof is being processed advantageously furthermore an at least thermally conductive composite material that is based on rubber and/or plastic.

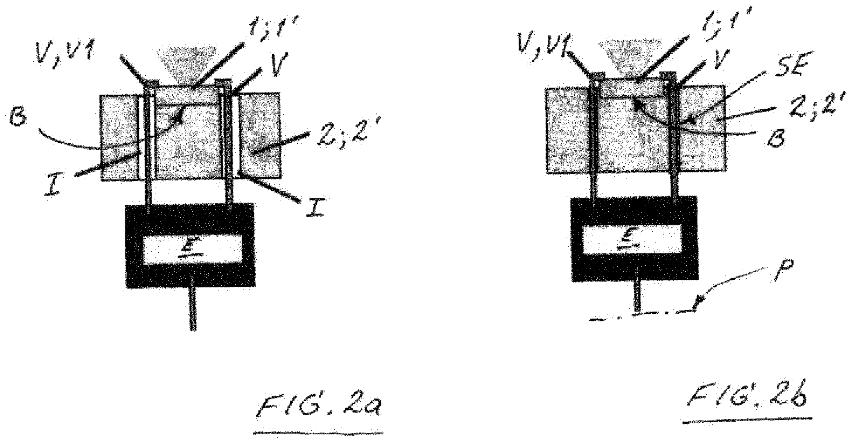

In connection with the LED light source 1; 1', 2 presented in figures 1a and 1b, being based on manual manufacturing, there has been exploited electronics E, being coupled in an integral manner with the frame part, as explained above, and also on the other being apart from the frame part, the electronics being coupled with the LED component electrically. When applying the method, a corresponding composition can be carried out by using thermally conductive plastic based manufacturing material forming the frame part 2; 2' e.g. on the principles presented in figures 2a and 2b, in which case due to a more or less electrically conductive frame part 2', the conductors V, connecting the LED component 1' and the electronics E operating the same, exist in an air space I in the frame part or the conductors being coated or covered by an electrically insulating material SE.

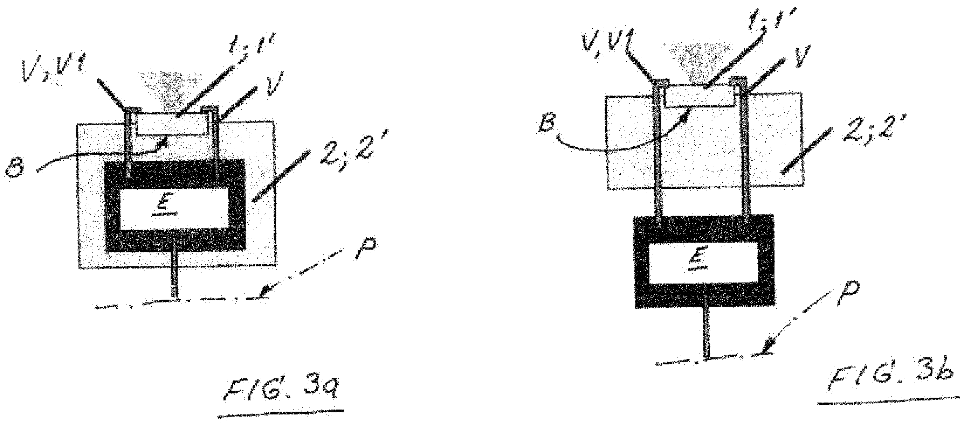

Particularly, as an alternative embodiment, with reference e.g. to the compositions presented e.g. in figures 3a - 3h, the actuator arrangement 1 is being coupled with the electronics E operating the same at least partly internally inside the plastic based frame part 2' by using in the processing an essentially electrically non-conductive manufacturing material, such as a manufacturing material containing e.g. ceramic, organic and/or mineral based substance.

As a further advantageous embodiment, the electrical conductors V and/or the electronics E, being coupled with the actuator arrangement 1 are being processed in an integral manner inside the frame part 2', in which case there is no need for the protective insulation in the first place.

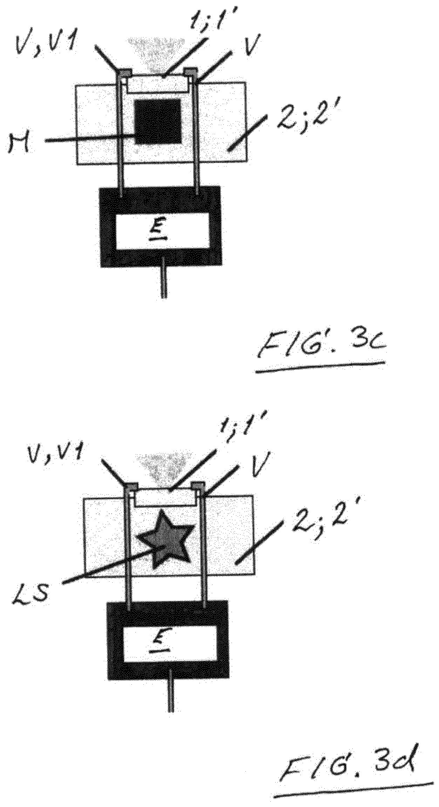

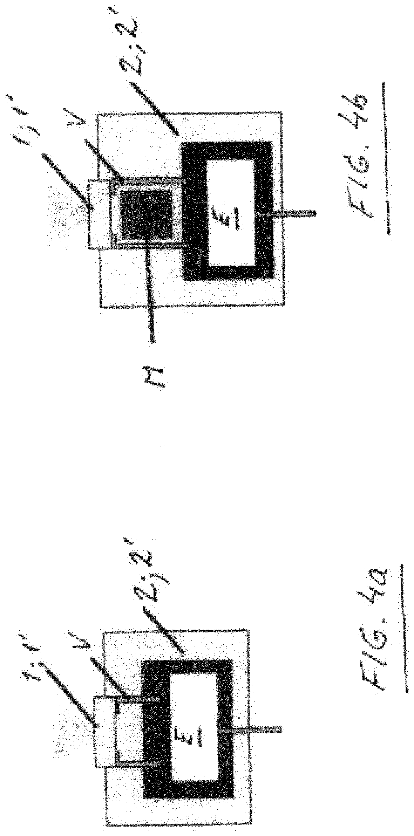

Furthermore as an advantageous embodiment, particularly with reference to the compositions presented in figures 3c and 4b, in connection with the processing, a cooling insert M made of metal, such as aluminium, is being installed inside the frame part 2; 2'. In this way it is possible to improve furthermore the thermal transmission/cooling properties of the frame part 2'.

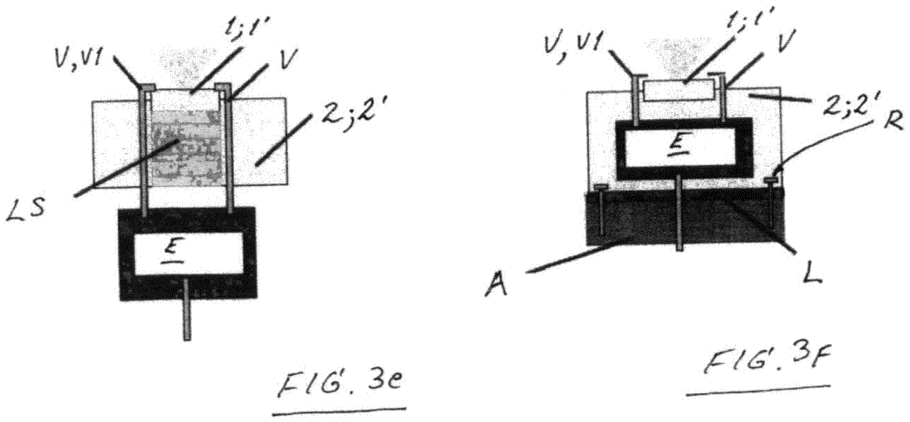

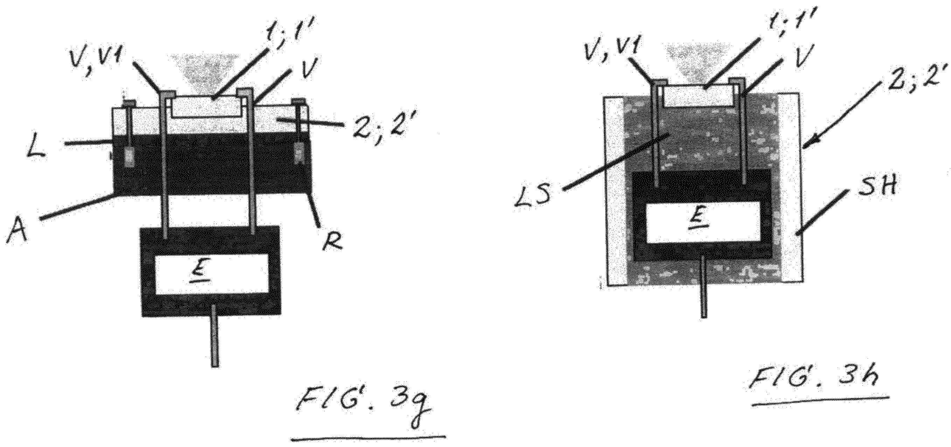

Furthermore as an advantageous embodiment, a two- or multi-component manufacturing is being exploited in the processing e.g. in order to achieve different parts of the frame part 2' to have thermal conductivity and/or electrical conductivity characteristics deviating from each other or for corresponding purpose. In the appended drawings, in the manufacturing of the compositions according to figures 3d and 3e, there has been applied the technique above by a material zone LS, being processed inside the frame part 2' that makes thermal transmission more efficient. Accordingly, in the composition according to figure 3h, there has been processed in this way in the center part of the frame part 2' a material zone LS that is thermally non-conductive and possibly also electrically non-conductive, in which case on the outer surface of the frame part there has been processed a material zone SH comprising cheaper customary plastics.

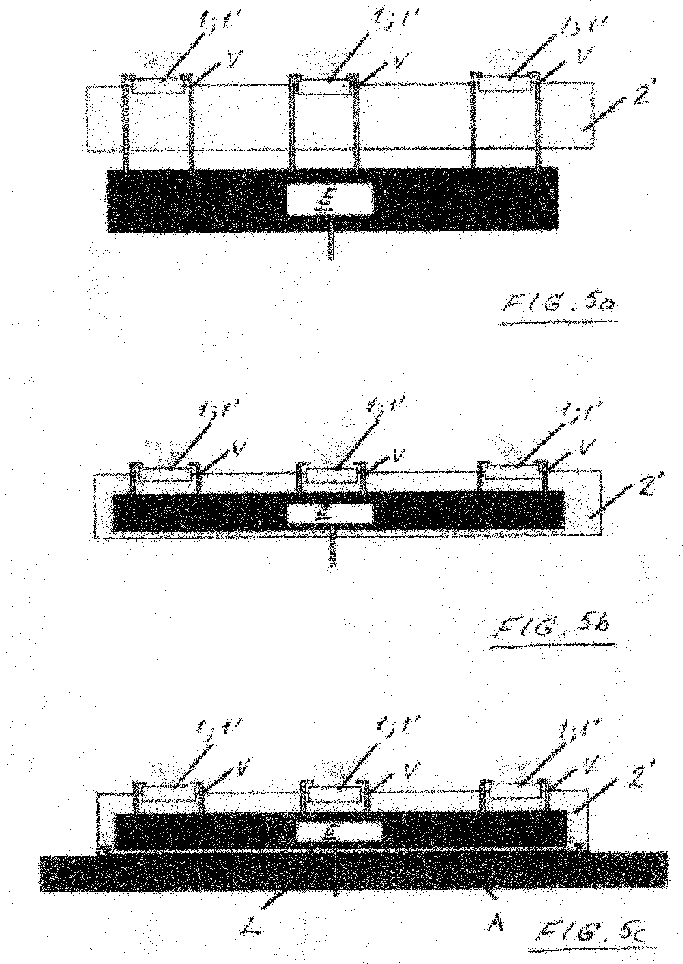

In connection with an actuator being manufactured according to the method, it is furthermore possible to exploit implementations known as such from prior art e.g. on the principles presented e.g. in figures 3f, 3g and 5c, in which case in connection with an actuator 1; 2', being manufactured by the method, is being coupled e.g. by a screw joint R possibly together with a thermally conductive paste or a tape layer L a metallic installation rail A e.g. made of aluminium, which for its part makes thermal transmission thus even more efficient.

The compositions presented in figures 4a and 4b are manufactured by using a LED component 1' according to figure 1d, in which the contact surfaces V1 are at the bottom surface of the component. In this kind of an implementation, an optimum composition is achieved particularly with a view to its moisture isolation characteristics, because all electrical operations of the actuator are thus closed inside the frame part 2' in a totally protected manner during the manufacturing process of the actuator. Furthermore in figures 5a and 5c are presented light units consisting of several LEDs 1', in which there has been used either external or integral electronics E. This kind of a lighting unit can be coupled by customary screw joints R as such e.g. on the principle shown in figure 5c and, when needed, by using a thermally insulating paste or tape L, with an actual installation rail A.

The invention is as defined by the appended claims.

## Claims

1. An electric actuator comprising an electric actuator arrangement (1) and a frame part (2; 2'), which the electric actuator arrangement (1) comprises one or more LED components (1'), and wherein the frame part (2; 2') is arranged against a heat exchange surface (B) of the electric actuator arrangement (1), and contact surfaces (V1) and electronics (E) of the one or more LED components (1') are arranged in an integral manner inside the electrically non-conductive frame part (2; 2'), which is formed by injection molding or die-casting thermosetting plastic, thermoplastic, vulcanized rubber or thermoplastic elastomer in connection with the electric actuator arrangement (1) so that a uniform light source is formed, the frame part (2; 2') is electrically non-conductive and is **characterized in that** it is configured to perform the thermal transmission of the electric actuator arrangement (1) and comprises inside the frame part (2; 2') an electrically non-conductive material zone (LS) having deviated thermal conductivity compared to the frame part (2; 2').

2. An electric actuator according to claim 1, wherein the actuator arrangement (1) is arranged to be coupled with the electronics (E) at least partly internally in the frame part (2; 2') by an electrically non-conductive manufacturing material.

3. An electric actuator according to claim 2, wherein the manufacturing material comprises ceramic, organic or mineral based substance.

4. An electric actuator according to any of the preceding claims 1-3, wherein the electric actuator further comprises a cooling insert arranged inside the frame part (2; 2').

5. An electric actuator according to any of the preceding claims 1-4, wherein different parts of the frame part (2; 2') are arranged to have thermal conductivity characteristics deviating from each other.

6. An electric actuator according to any of the preceding claims 1-5, wherein the actuator arrangement (1) is arranged at least partly inside the frame part (2, 2').

7. An electric actuator according to any of the preceding claims 1-6, wherein a bottom of the LED component (1') comprises at least thermally conductive composite material.

8. An electric actuator according to claim 7, wherein the material bases rubber and/or plastic.

9. An electric actuator according to any of the preceding claims 1-6, wherein the contact surfaces (V1) are at the bottom surface of the LED component (1').

## Patentansprüche

1. Elektrischer Aktuator mit einer elektrischen Aktuatoranordnung (1) und einem Rahmenteil (2; 2'), wobei die elektrische Aktuatoranordnung (1) ein oder mehrere LED-Bauteile (1') umfasst, und wobei das Rahmenteil (2; 2') an einer Wärmeaustauschfläche (B) der elektrischen Aktuatoranordnung (1) angeordnet ist und Kontaktflächen (V1) und Elektronik (E) der einen oder mehreren LED-Komponenten (1') einstückig innerhalb des elektrisch nicht leitenden Rahmenteils (2; 2') angeordnet sind, das durch Spritzgießen oder Druckgießen von duroplastischem Kunststoff, Thermoplast, vulkanisiertem Gummi oder thermoplastischem Elastomer in Verbindung mit der elektrischen Aktuatoranordnung (1) gebildet ist, so dass eine gleichmäßige Lichtquelle entsteht, das Rahmenteil (2; 2') elektrisch nichtleitend ist, und **dadurch gekennzeichnet ist, dass** er dazu konfiguriert ist, die Wärmeübertragung der elektrischen Aktuatoranordnung (1) durchzuführen, und innerhalb des Rahmenteils (2; 2') eine elektrisch nicht leitende Materialzone (LS) mit gegenüber dem Rahmenteil (2; 2') abweichender Wärmeleitfähigkeit aufweist.

2. Elektrischer Aktuator nach Anspruch 1, **dadurch gekennzeichnet, dass** die Aktuatoranordnung (1) zumindest teilweise intern im Rahmenteil (2; 2') durch ein elektrisch nicht leitendes Herstellungsmaterial mit der Elektronik (E) koppelbar angeordnet ist.

3. Elektrischer Aktuator nach Anspruch 2, wobei das Herstellungsmaterial eine keramische, organische oder mineralbasierte Substanz umfasst.

4. Elektrischer Aktuator nach einem der vorhergehenden Ansprüche 1 bis 3, wobei der elektrische Aktuator ferner einen innerhalb des Rahmenteils (2; 2') angeordneten Kühleinsatz umfasst.

5. Elektrischer Aktuator nach einem der vorhergehenden Ansprüche 1 bis 4, wobei verschiedene Teile des Rahmenteils (2; 2') so angeordnet sind, dass sie voneinander abweichende Wärmeleitfähigkeitseigenschaften aufweisen.

6. Elektrischer Aktuator nach einem der vorhergehenden Ansprüche 1 bis 5, wobei die Aktuatoranordnung (1) zumindest teilweise innerhalb des Rahmenteils (2, 2') angeordnet ist.

7. Elektrischer Aktuator nach einem der vorhergehenden Ansprüche 1 bis 6, wobei eine Unterseite der LED-Komponente (1') zumindest wärmeleitfähiges Verbundmaterial umfasst.

8. Elektrischer Aktuator nach Anspruch 7, **dadurch gekennzeichnet, dass** das Material auf Gummi und/oder Kunststoff basiert.

9. Elektrischer Aktuator nach einem der vorhergehenden Ansprüche 1 bis 6, wobei sich die Kontaktflächen (V1) an der unteren Fläche der LED-Komponente (1') befinden.

## Revendications

1. Actionneur électrique comprenant un agencement d'actionneur électrique (1) et une partie de cadre (2 ; 2'), lequel agencement d'actionneur électrique (1) comprend un ou plusieurs composants DEL (1'), et dans lequel la partie de cadre (2 ; 2') est agencée contre une surface d'échange de chaleur (B) de l'agencement d'actionneur électrique (1), et des surfaces de contact (V1) et des composants électroniques (E) des un ou plusieurs composants DEL (1') sont agencés de manière intégrale à l'intérieur de la partie de cadre (2 ; 2') électriquement non conductrice, qui est formée par moulage par injection ou moulage sous pression de plastique thermodurcissable, de thermoplastique, de caoutchouc vulcanisé ou d'élastomère thermoplastique en relation avec l'agencement d'actionneur électrique (1) de sorte qu'une source de lumière uniforme est formée, la partie de cadre (2 ; 2') est électriquement non conductrice et est **caractérisée en ce qu'**elle est conçue pour réaliser la transmission thermique de l'agencement d'actionneur électrique (1) et comprend à l'intérieur de la partie de cadre (2 ; 2') une zone de matériau électriquement non conducteur (LS) ayant une conductivité thermique déviée par rapport à la partie de cadre (2 ; 2').

2. Actionneur électrique selon la revendication 1, dans lequel l'agencement d'actionneur (1) est agencé pour être couplé aux composants électroniques (E) au moins partiellement intérieurement dans la partie de cadre (2 ; 2') par un matériau de fabrication électriquement non conducteur.

3. Actionneur électrique selon la revendication 2, dans lequel le matériau de fabrication comprend une substance à base de céramique, organique ou minérale.

4. Actionneur électrique selon l'une quelconque des revendications précédentes 1 à 3, dans lequel l'actionneur électrique comprend en outre un insert de refroidissement agencé à l'intérieur de la partie de cadre (2 ; 2').

5. Actionneur électrique selon l'une quelconque des revendications précédentes 1 à 4, dans lequel différentes parties de la partie de cadre (2 ; 2') sont agencées pour avoir des caractéristiques de conductivité thermique divergeant les unes des autres.

6. Actionneur électrique selon l'une quelconque des revendications précédentes 1 à 5, dans lequel l'agencement d'actionneur (1) est agencé au moins partiellement à l'intérieur de la partie de cadre (2, 2').

7. Actionneur électrique selon l'une quelconque des revendications précédentes 1 à 6, dans lequel une partie inférieure du composant DEL (1') comprend au moins un matériau composite thermoconducteur.

8. Actionneur électrique selon la revendication 7, dans lequel le matériau est à base de caoutchouc et/ou de plastique.

9. Actionneur électrique selon l'une quelconque des revendications précédentes 1 à 6, dans lequel les surfaces de contact (V1) sont au niveau de la surface inférieure du composant DEL (1').
